# EUROPEAN PATENT APPLICATION

(11) **EP 1 980 894 A2**
(43) Date of publication of application: **15.10.2008**
(21) Application number: 08006503.0
(22) Date of filing: 31.03.2008
(51) Int. Cl.: G02B 26/00

(54) **Deformable mirror**

(30) Priority: 10.04.2007 JP 2007103215
(71) Applicant: Olympus Corporation, Tokyo 151-0072 (JP)
(72) Inventor: Ohara, Satoshi, Hachioji-shi Tokyo 192-8512 (JP)
(74) Representative: Röss, Walter Josef Alfred

(57) **Abstract**

A deformable mirror includes a flexible thin film (103). A holding member (101) holds the flexible thin film (103). An operating member (105) is configured to be actuated as the flexible thin film (103) bends. A film-side opposite electrode is disposed on the flexible thin film (103). Holding-member-side bonding pads are disposed individually in positions symmetrical with respect to a center point of the flexible thin film (103) or to a straight line which passes through the center point. A board (102) is disposed opposite the holding member (101). A board-side opposite electrode (106) is disposed on the board (102) so as to face the film-side opposite electrode.

Board-side bonding pads (109) are disposed on the board (102) so as to face the holding-member-side bonding pads , individually. Intermediate members (110) are sandwiched individually between the holding-member-side bonding pads and the board-side bonding pads (109).

## Description

The present invention relates to a deformable mirror having a continuously variable curvature.

A mounting structure for a deformable mirror having a continuously variable curvature is proposed in, for example, Jpn. Pat. Appln. KOKAI Publication No. 2002-156514. According to this proposal, thick photoresist films that are formed by spin coating are used as uniform-thickness spacers with an adhesive function. The uniform-thickness spacers can reduce a load produced when a substrate that includes a flexible thin film is bonded to a substrate that includes electrodes for driving the flexible thin film. Thus, a. distortion of the substrate that includes the flexible thin film can be suppressed when the substrates are bonded together.

In the structure proposed in Jpn. Pat. Appln. KOKAI Publication No. 2002-156514, a holding member that holds the flexible thin film is in surface contact with the photoresist spacers. Therefore, dispersions of mounting loads and a fixing force after mounting within a contact surface may possibly cause a distortion of the holding member. If the holding member singly has a distortion before it is mounted, moreover, only some of the spacers contact the holding member in the mounting structure based on surface contact. In this case, an unbalanced load may possibly be produced in the holding member during a mounting operation.

The object of the present invention is to provide a deformable mirror having a structure configured to additionally suppress a distortion after mounting.

According to first aspect of the invention, there is provided a deformable mirror comprising: a flexible thin film (103); a holding member (101) which holds the flexible thin film (103) so that the flexible thin film (103) is bendable; an operating member (105) which is attached to the flexible thin film (103) and configured to be actuated as the flexible thin film (103) bends; a film-side opposite electrode (104) which is disposed on the flexible thin film (103) and spread along the flexible thin film (103); a plurality of holding-member-side bonding pads (108) which are disposed individually in positions symmetrical with respect to a center point of the flexible thin film (103) on the holding member (101) or to a straight line which passes through the center point; a board (102) which is disposed opposite the holding member (101); a board-side opposite electrode (106) which is disposed on the board (102) so as to face the film-side opposite electrode (104) and produces an electrostatic force between the film-side opposite electrode (104) and the board-side opposite electrode (106), being configured to bend the flexible thin film (103) by means of the electrostatic force; a plurality of board-side bonding pads (109) which are disposed on the board (102) so as to face the holding-member-side bonding pads (108), individually; and intermediate members (110) which are sandwiched individually between the holding-member-side bonding pads (108) and the board-side bonding pads (109), fix the holding member (101) and the board (102) with a predetermined space therebetween, and electrically connect the holding-member-side bonding pads (108) and the board-side bonding pads (109).

The invention can be more fully understood from the following detailed description when taken in conjunction with the accompanying drawings, in which:
FIG. 1 is a sectional view showing a configuration of a deformable mirror according to a first embodiment of the invention;
FIG. 2 is a perspective view of the deformable mirror of the first embodiment;
FIG. 3 is a view showing stresses on the deformable mirror of the first embodiment, produced by mounting loads and a fixing force after mounting;
FIG. 4 is a view showing the mounting loads and the fixing force after mounting for the case of fixation based on surface contact;
FIG. 5 is a view showing the mounting loads and the fixing force after mounting for the case of fixation based on point contact;
FIGS. 6A and 6B are views showing modifications of the arrangement of junctions;
FIG. 7 is a sectional view showing a configuration of a deformable mirror according to a second embodiment of the invention;
FIG. 8 is a perspective view of the deformable mirror of the second embodiment; and
FIG. 9 is a view showing a modification of the construction of junctions.

Embodiments of the present invention will now be described with reference to the accompanying drawings.

### [First Embodiment]

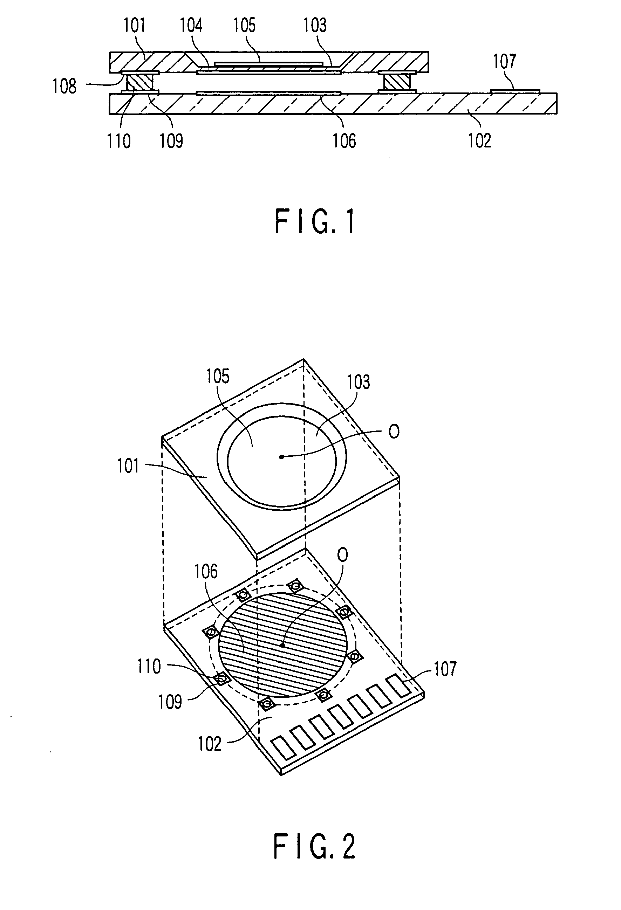

A first embodiment of the invention will be described first. FIG. 1 is a sectional view showing a configuration of a deformable mirror according to the first embodiment. FIG. 2 is a perspective view of the deformable mirror shown in FIG. 1.

In the deformable mirror shown in FIG. 1, a mirror substrate 101 of, e.g., silicon, as an example of a holding member, and a wiring board 102 of, e.g., silicon dioxide, as an example of a board, are located opposite each other.

As shown in FIG. 2, moreover, a maximum-area surface (obverse or reverse surface in FIG. 2) of the mirror substrate 101 is in the form of a square. A circular spot facing portion is formed near the center of this square. A center O of the spot facing portion is coincident with the center of gravity of the square that forms the mirror substrate 101. Further, a silicon film of about 1 µm-thickness is left as a flexible thin film 103 on the spot facing portion. The flexible thin film 103 is held so as to be bendable by the mirror substrate 101 around it. As shown in FIG. 1, moreover, a film-side opposite electrode 104 for deforming the flexible thin film 103 into a desired shape is disposed on that surface of the film 103 which faces the wiring board 102. Furthermore, a reflective film 105 is attached to that surface of the flexible thin film 103 opposite from the surface that faces the wiring board 102. The reflective film 105 is an example of an operating member that serves to reflect an optical input.

As shown in FIG. 1, moreover, a wiring-board-side opposite electrode 106 for deforming the flexible thin film 103 into a desired shape is disposed on that surface of the wiring board 102 which faces the mirror substrate 101. The electrode 106 corresponds in shape to the film-side opposite electrode 104. Further, external connection pads 107 are arranged on a part of the wiring board 102. The external connection pads serve to input drive signals to the board-side opposite electrode 106.

As shown in FIG. 1, furthermore, mirror-substrate-side bonding pads 108 are arranged on the mirror substrate 101, and wiring-board-side bonding pads 109 on the wiring board 102. The substrate-side bonding pads 108 are wired to the film-side opposite electrode 104. The board-side bonding pads 109 are wired to the board-side opposite electrode 106 and the external connection pads 107.

The substrate-side bonding pads 108 on the mirror substrate 101 are bonded mechanically and electrically to the board-side bonding pads 109 on the wiring board 102 by Au bumps 110 as an example of intermediate members (conductive protrusions). Each Au bump 110 is composed of a simple or composite Au bump that locally contacts the mirror substrate 101 so that the ratio of the bonded area to the area of the substrate 101 is 0.1% or less (for one junction).

In the present embodiment, the substrate-side bonding pads 108 are located in the vicinity of the flexible thin film 103 and symmetrically with respect to the center point O that doubles as both the center of the contour of the mirror substrate 101 and the center point of the spot facing portion. Also, the board-side bonding pads 109 are located opposite the substrate-side bonding pads 108, individually. More specifically, four pairs of substrate-side and board-side bonding pads 108 and 109 are arranged at equal distances from the point O and in the shape of a cross, as shown in FIG. 2. At least one pair of substrate-side and board-side bonding pads 108 and 109 are arranged at equal distances from the point O in each of four regions (quadrants) that are divided by the four pairs of pads 108 and 109. Preferably, the latter pairs of substrate-side and board-side bonding pads 108 and 109, as well as former four pairs of substrate-side and board-side bonding pads 108 and 109, should be arranged at regular angular intervals. Above all, the eight pairs of bonding pads 108 and 109 should be arranged at angular intervals of 45°, as shown in FIG. 2. In the foregoing description, moreover, the substrate-side bonding pads 108 are described as being located in the vicinity of the flexible thin film 103 to imply the distances from the point O set when the pads 108 are arranged symmetrically with respect to the point. Preferably, in order to reduce a distortion of the flexible thin film 103, the distances between the point O and the substrate-side bonding pads 108 should be minimized without failing to ensure the manufacture of the mirror substrate 101 and the Au bumps 110. By shortening the distances between the pads 108 and the point O, the distances between the pads 108 and the bumps 110 that are arranged symmetrically with respect to the point can be reduced. Specifically, intervals between points at which the mirror substrate 101 is fixed by the bumps 110 can be shortened, so that the mirror substrate 101 can be fixed without further distorting the flexible thin film 103 that is surrounded by the pads 108 and the bumps 110.

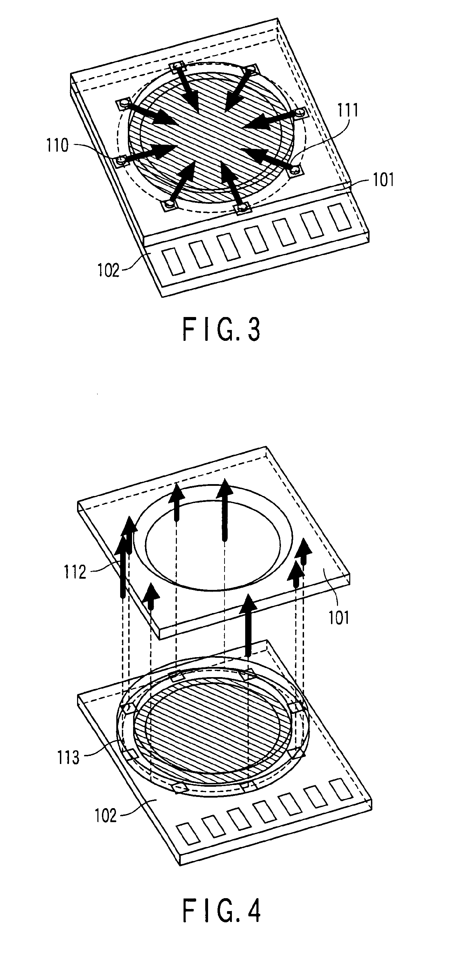

Thus, the substrate-side and board-side bonding pads 108 and 109 are arranged so that junctions between the mirror substrate 101 and the wiring board 102 are located symmetrically with respect to the center point O of the contour of the mirror substrate 101. By doing this, stresses 111 that are produced by mounting loads and a fixing force after mounting can be controlled so that they cancel one another, as shown in FIG. 3. Thus, the distortion of the mirror substrate 101 can be minimized when the mirror substrate 101 and the wiring board 102 are fixed together.

Since the Au bumps 110 are used to bond together the mirror substrate 101 and the wiring board 102, moreover, the mirror substrate 101 can be fixed by point contact.

If the mirror substrate 101 is fixed by surface contact using an adhesive agent 113 as a bonding member, as shown in FIG. 4, for example, the curing rate of the adhesive agent 113 and an adhesive area vary considerably. In this case, it is difficult to keep mounting loads 112 and the fixing force after mounting uniform within an adhesive surface. Therefore, the mirror substrate 101 may highly possibly be distorted after mounting. If the mirror substrate 101 is fixed by surface contact using a bonding member of any other resin or metal, moreover, voids are produced in a bonded surface on the mirror substrate, so that it is difficult to keep the mounting loads and the fixing force after mounting uniform within a contact surface.

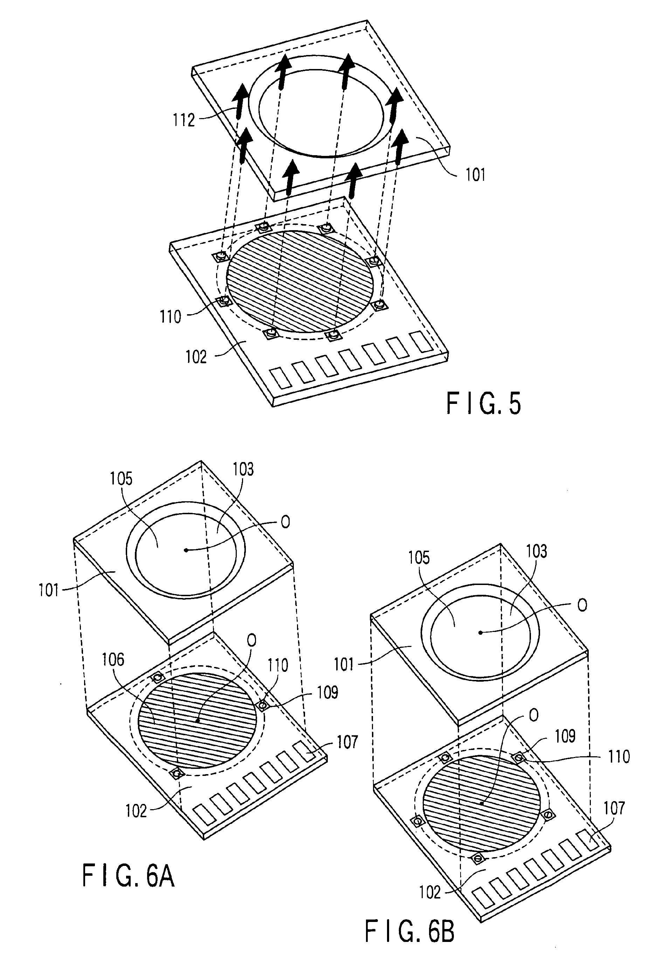

If the mirror substrate 101 is fixed by point contact with use of the Au bumps 110, on the other hand, the junctions can be arranged with high accuracy equivalent to the manufacturing accuracy of the bumps. Besides, the height of the Au bumps 110 can be controlled highly accurately. As shown in FIG. 5, therefore, uniform mounting loads 112 can be applied at all the junctions at the time of mounting. Thus, the fixing force after mounting can also be kept uniform within the contact surface on the mirror substrate 101.

According to the first embodiment, as described above, the junctions between the mirror substrate 101 and the wiring board 102 are arranged symmetrically with respect to the point, and the bonding at the junctions is based on point contact, so that the mirror substrate 101 can be bonded without being distorted. Thus, the distortion of the flexible thin film 103 on the mirror substrate 101 after mounting can be reduced. By locating the junctions in the vicinity of the flexible thin film 103, moreover, dispersions of the mounting stresses can be reduced to enhance the effect of reduction of the distortion after mounting.

In the first embodiment, the junctions are arranged symmetrically with respect to the point. If the stresses on the symmetrical junctions are cancelled, however, the junctions need not always be arranged with respect to a point. Possibly, for example, the junctions may be arranged symmetrically with respect to a straight line that passes through the center point O or on the vertexes of a regular polygon (which may be any one other than the regular octagon shown in FIG. 2) that is inscribed in a concentric circle around the center O. FIG. 6A shows a case where three junctions are arranged at regular intervals of 120° around the center point O (i.e., on the vertexes of a regular triangle). FIG. 6B shows a case where five junctions are arranged at regular intervals of 72° around the center point O (i.e., on the vertexes of a regular pentagon). Alternatively, four junctions may be arranged at intervals of 90° or twelve junctions may be arranged at intervals of 30°. The same effect of the first embodiment can also be obtained with these configurations.

The following is a description of a method for manufacturing the deformable mirror shown in FIGS. 1 and 2.

The mirror substrate 101 and the wiring board 102 can be manufactured with high accuracy by using the so-called micro-electromechanical systems (MEMS) technology based on semiconductor manufacturing techniques. In the following paragraphs, a description of the manufacture of the mirror substrate 101 and the wiring board 102 is omitted, and a method for mounting them will be described in detail.

First, the Au bumps 110 are formed on the board-side bonding pads 109 that are arranged on the wiring board 102. If the board-side bonding pads 109 are fabricated by conventional photolithographic processes, its positional accuracy is about ±1 µm, while that of the Au bumps 110 is about ±5 µm. One Au bump 110 or an aggregate of bumps may be formed for each junction. After the Au bumps 110 are fabricated on the wiring board 102, the wiring board 102 and the mirror substrate 101 are fixed individually on upper and lower stages of a mounting machine (not shown) by vacuum suction. After the wiring board 102 and the mirror substrate 101 on the stages are aligned with each other by using a camera, the mirror substrate 101 is brought into contact with the Au bumps 110 on the wiring board 102. Thereafter, the resulting structure is pressurized and heated, whereby the substrate-side bonding pads 108 and the Au bumps 110 are joined together by solid-phase diffusion bonding. A load applied during this operation is set so that a space between the mirror substrate 101 and the wiring board 102 is adjusted to a desired value. Further, the mounting may be preceded by plasma cleaning of the mirror substrate 101 and/or the wiring board 102 having the fabricated bumps 110 thereon before bonding. A load for obtaining desired bond strength can be reduced by plasma-cleaning the mounting surface. Thus, the distortion after mounting can be further suppressed. Since the substrate or board is mounted after the alignment by means of the camera, moreover, XY accuracy for mounting is about ±5 µm. Based on these mounting processes, a design deviation from the junction position is about 11 µm at the maximum. Thus, it is believed that there is no possibility of positional deviations of the junctions breaking the symmetry of the arrangement of the junctions and influencing the distortion suppression effect.

### [Second Embodiment]

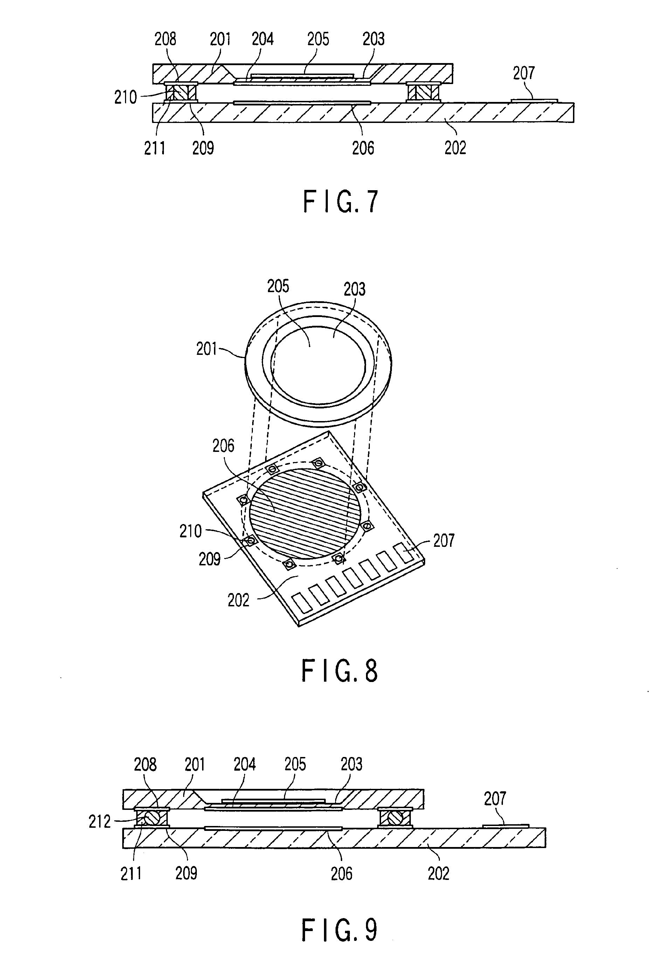

The following is a description of a second embodiment of the invention. FIG. 7 is a sectional view showing a configuration of a deformable mirror according to the second embodiment. FIG. 8 is a perspective view of the deformable mirror.

In the deformable mirror shown in FIG. 7, a mirror substrate 201 of, e.g., silicon and a wiring board 202 of, e.g., silicon dioxide are located opposite each other.

As shown in FIG. 8, moreover, a maximum-area surface of the mirror substrate 201 is in the form of a circle. A circular spot facing portion is located near the center of this circle. The center of the spot facing portion is coincident with the center of the contour of the mirror substrate 201.

As in the case of the first embodiment, furthermore, a flexible thin film 203, a film-side opposite electrode 204, a reflective film 205, and a mirror-substrate-side bonding pads 208 are fabricated on the mirror substrate 201, as shown in FIG. 7. Further, a wiring-board-side opposite electrode 206, wiring-board-side bonding pads 209, and external connection pads 207 are fabricated on the wiring board 202. Furthermore, the mirror substrate 201 and the wiring board 202 are individually wired as required to drive the flexible thin film 203.

As shown in FIG. 7, moreover, Au bumps 210 as an example of intermediate members (conductive protrusions) are arranged between the mirror substrate 201 and the wiring board 201. The peripheries of the Au bumps 210 are bonded together by a solder 211. The Au bumps 210 serve as spacers for maintaining a space between the mirror substrate 201 and the wiring board 202 (for which mounting procedure will be described in detail later) and are not concerned with bonding. The solder 211 around the Au bumps 210 serves for electrical and mechanical bonding between the mirror substrate 201 and the wiring board 202. The arrangement of the junctions between the mirror substrate 201 and the wiring board 202 is symmetrical with respect to a point, as in the first embodiment. Although the Au bumps are used as the spacers in the second embodiment, they may be replaced with, for example, Cu balls 212 for mounting that are surface-coated with the solder 211, as shown in FIG. 9.

The second embodiment differs from the first embodiment in the external shape of the mirror substrate 201 and the construction of the junctions. According to the second embodiment, the external shape of the mirror substrate 201 is circular, so that mounting loads and a fixing force after mounting are applied from the junctions that are arranged symmetrically with respect to the point. Thus, equal stresses are produced at points on a concentric circle around the center of the flexible thin film 203 inside the mirror substrate 201, so that the stresses can be made more uniform than in the first embodiment. Accordingly, an effect can be obtained to additionally suppress a distortion after mounting. According to the first embodiment, moreover, the Au bumps 110 are joined together by solid-phase diffusion bonding. In the second embodiment, however, the Au bumps 210 are used as the spacers, and the solder 211 is used for bonding. If the solder 211 is used for bonding, as in the second embodiment, a load that is applied in mounting the mirror substrate 201 and the wiring board 202 can be reduced. Thus, an effect can be obtained to further suppress a distortion after mounting.

The following is a description of a method for manufacturing the deformable mirror according to the second embodiment. In the following paragraphs, as in the case of the first embodiment, a description of the manufacture of the mirror substrate 201 and the wiring board 202 is omitted, and a method for mounting them will be described in detail.

First, the Au bumps 210 are formed on the board-side bonding pads 209 on the wiring board 202. One Au bump 210 or an aggregate of bumps may be fabricated for each junction. Solder balls are fed onto the Au bumps 210. After the mirror substrate 201 and the wiring board 202 having the fabricated bumps 210 thereon are fixed on a mounting machine (not shown), they are aligned with each other and then pressurized and heated. Thereupon, the solder balls on the Au bumps 210 are melted and used to mount the mirror substrate 201 and the wiring board 202.

The flexible thin film has been described as being circular in connection with each of the foregoing embodiments. Alternatively, however, it may be in the shape of a regular polygon or ellipse, for example. Further, materials of the substrate or board are not limited to silicon and silicon dioxide. Besides, members for bonding are not limited to Au bumps and solder.

## Claims

1. A deformable mirror **characterized by** comprising:
a flexible thin film (103);
a holding member (101) which holds the flexible thin film (103) so that the flexible thin film (103) is bendable;
an operating member (105) which is attached to the flexible thin film (103) and configured to be actuated as the flexible thin film (103) bends;
a film-side opposite electrode (104) which is disposed on the flexible thin film (103) and spread along the flexible thin film (103);
a plurality of holding-member-side bonding pads (108) which are disposed individually in positions symmetrical with respect to a center point of the flexible thin film (103) on the holding member (101) or to a straight line which passes through the center point;
a board (102) which is disposed opposite the holding member (101);
a board-side opposite electrode (106) which is disposed on the board (102) so as to face the film-side opposite electrode (104) and produces an electrostatic force between the film-side opposite electrode (104) and the board-side opposite electrode (106), being configured to bend the flexible thin film (103) by means of the electrostatic force;
a plurality of board-side bonding pads which are (109) disposed on the board (102) so as to face the holding-member-side bonding pads (108), individually; and
intermediate members (110) which are sandwiched individually between the holding-member-side bonding pads (108) and the board-side bonding pads (109), fix the holding member (101) and the board (102) with a predetermined space therebetween, and electrically connect the holding-member-side bonding pads (108) and the board-side bonding pads (109).

2. A deformable mirror according to claim 1, **characterized in that** the point-symmetrical positions are positions on a concentric circle around the center point of the flexible thin film (103).

3. A deformable mirror according to claim 2, **characterized in that** the positions on the concentric circle are positions which are situated on the concentric circle around the center point of the flexible thin film (103) and in which the holding-member-side bonding pads (108) are arranged at regular intervals.

4. A deformable mirror according to any one of claims 1 to 3, **characterized in that** each of the intermediate members (110) is formed of an electrically conductive protrusion.

5. A deformable mirror according to any one of claims 1 to 3, **characterized in that** each of the intermediate members (110) is formed of a spacer and a solder.

6. A deformable mirror according to claim 5, **characterized in that** the spacer is an electrically conductive protrusion (210).

7. A deformable mirror according to claim 5, **characterized in that** the spacer is a metallic ball (212).

8. A deformable mirror according to claim 1, **characterized in that** the holding-member-side bonding pads (108) are individually located in the vicinity of the flexible thin film (103).

9. A deformable mirror according to any one of claims 1 to 3, **characterized in that** the holding member (101) has a shape symmetrical with respect to the center point of the flexible thin film (103) or to a straight line which passes through the center point.

10. A deformable mirror according to claim 9, **characterized in that** the point-symmetrical shape is a shape such that a contour of the holding member (101) is a concentric circle around the center point of the flexible thin film (103).
